# EUROPEAN PATENT APPLICATION

(11) **EP 4 645 620 A1**
(43) Date of publication of application: **05.11.2025**
(21) Application number: 23911397.0
(22) Date of filing: 08.11.2023
(51) Int. Cl.: H02H 3/00, G01R 31/12, H02H 3/52, H02H 7/12

(54) **POWER SUPPLY SYSTEM**

(30) Priority: 26.12.2022 JP 2022208022
(71) Applicant: Kaneka Corporation, Osaka-shi, Osaka 530-8288 (JP)
(72) Inventor: NISHIYAMA, Haruo, Osaka-shi, Osaka 530-8288 (JP)
(74) Representative: Hoffmann Eitle
(86) International application number: PCT/JP2023/040158
(87) International publication number: WO 2024/142613

(57) **Abstract**

The present invention provides a power supply system capable of identifying a location where series arc discharge or parallel arc discharge occurs. It is configured that a noise detection means is provided in a positive-electrode-side wiring portion or a negative-electrode-side wiring portion and is located closer to a power supply module than a connection portion with a bypass wiring portion, and an arc determination unit determines that series arc discharge has occurred closer to the power supply module than the bypass wiring portion when a condition (1) or (2) below is satisfied. (1) A series switch unit is closer to the power supply module than the bypass wiring portion, and the arc detection unit detects series arc discharge and the noise detection means detects predetermined current noise or predetermined high frequency noise in a state where the series switch unit is closed and a parallel switch unit is closed. (2) A series switch unit is closer to a power conversion device than the bypass wiring portion, and the arc detection unit detects series arc discharge and the noise detection means detects predetermined current noise or predetermined high frequency noise in a state where a parallel switch unit is closed.

## Description

### TECHNICAL FIELD

The present invention relates to a power supply system including a power supply module such as a solar cell module and a power conversion device.

### BACKGROUND ART

Conventionally, a solar power generation system includes a solar cell module and a power conversion device, and DC power generated by the solar cell module can be converted into AC power by the power conversion device and supplied to a commercial power supply grid.

In a conventional solar power generation system, there is a possibility that fires may rarely occur after several years have elapsed after installation. Such a fire is often caused mainly by an arc discharge that occurs at places where a cable is pinched at the time of construction, a scratch on the cable, and a contact failure of a connector portion are left as they are with aging deterioration.

The arc discharge can be roughly classified into series arc discharge and parallel arc discharge depending on a place where the arc discharge occurs on a circuit.

The series arc discharge occurs in a case where a current passes through a conductive wire in a series circuit, and the parallel arc discharge occurs in a case where a current passes between two conductive wires connected in parallel in a parallel circuit.

The series arc discharge can be extinguished by cutting off the series circuit, whereas the parallel arc discharge can be extinguished by short-circuiting the parallel circuit and making the potential difference across the conductive wires 0 V, and the method of handling the arc discharge differs depending on the type of the arc discharge.

For this reason, conventionally, in order to extinguish the arc discharge, it is necessary to extinguish the arc discharge after specifying it whether the series arc discharge or the parallel arc discharge with a corresponding method to the specified arc discharge, resulting in a problem of delayed handling to the arc discharge.

Therefore, Patent Document 1 proposes a protection method capable of extinguishing arc discharge of both series arc discharge and parallel arc discharge.

Specifically, in the protection method of Patent Document 1, first, in a case where arc discharge is detected by an arc detection unit in a solar cell string, series arc-extinguishing control is executed in which a series electric path through which a current flows to the solar cell string through a power conversion circuit of a power conditioning system is cut off by a series switch, and parallel arc-extinguishing control is executed in which a parallel electric path through which a current flows to the string without passing through the power conversion circuit is formed by a parallel switch.

In a case where the arc discharge is detected by the arc detection unit in a state in which the series electric path is cut off by the series switch and the parallel electric path is formed by the parallel switch after the series arc-extinguishing control and the parallel arc-extinguishing control, after detecting the occurrence of the series arc discharge in the solar cell string and executing the series arc-extinguishing control and the parallel arc-extinguishing control, the occurrence of the parallel arc discharge in the solar cell string is detected when the arc discharge is detected by the arc detection unit in a state in which both the series electric path and the parallel electric path are cut off by the series switch and the parallel switch.

Then, in a case where the series arc discharge in the solar cell string is detected, the parallel electric path is cut off by the parallel switch, and in a case where the parallel arc discharge in the solar cell string is detected, the parallel electric path is conducted by the parallel switch.

### PRIOR ART DOCUMENTS

### PATENT DOCUMENTS

Patent Document 1: JP 2022-80747 A

### DISCLOSURE OF INVENTION

### TECHNICAL PROBLEM

Meanwhile, in a case where arc discharge occurs, when the degree of severity is high, maintenance of a location where the arc discharge occurs may be immediately required. Furthermore, even if the severity is low, it is necessary to maintain the location where the arc discharge occurs in the periodic maintenance.

However, in the protection method of Patent Document 1, the location where the arc discharge occurs cannot be identified, and it is necessary to inspect all the portions between the solar cell string and the power conversion circuit at the time of maintenance.

Therefore, an object of the present invention is to provide a power supply system capable of identifying a location where series arc discharge or parallel arc discharge occurs.

### SOLUTION TO PROBLEM

One aspect of the present invention for solving the above-described problem is a power supply system including: a power supply module; a power conversion device; an arc detection unit; a positive-electrode-side wiring portion; a negative-electrode-side wiring portion; a bypass wiring portion; a series switch unit; a parallel switch unit; and an arc determination unit, in which the power supply module is connected to the power conversion device via the positive-electrode-side wiring portion and the negative-electrode-side wiring portion, the arc detection unit is capable of detecting series arc discharge in a portion closer to the power supply module than the power conversion device and includes a noise detection means, the bypass wiring portion connects the positive-electrode-side wiring portion and the negative-electrode-side wiring portion, the series switch unit is provided in the positive-electrode-side wiring portion or the negative-electrode-side wiring portion, the parallel switch unit is provided in a middle of the bypass wiring portion and is connected in parallel with the power conversion device, the noise detection means is provided in the positive-electrode-side wiring portion or the negative-electrode-side wiring portion and is located closer to the power supply module than a connection portion with the bypass wiring portion, and the arc determination unit determines that the series arc discharge has occurred closer to the power supply module than the bypass wiring portion when a condition (1) or (2) below is satisfied.
(1) The series switch unit is closer to the power supply module than the bypass wiring portion, and the arc detection unit detects series arc discharge and the noise detection means detects predetermined current noise or predetermined high frequency noise in a state where the series switch unit is closed and the parallel switch unit is closed.
(2) The series switch unit is closer to the power conversion device than the bypass wiring portion, and the arc detection unit detects series arc discharge and the noise detection means detects predetermined current noise or predetermined high frequency noise in a state where the parallel switch unit is closed.

According to this aspect, since it is possible to determine whether or not series arc discharge has occurred closer to the power supply module than the bypass wiring portion, it is possible to identify the location where series arc discharge has occurred and to facilitate the subsequent maintenance work and the like.

In a preferred aspect, the arc determination unit determines that the series arc discharge has occurred closer to the power conversion device than the bypass wiring portion when a condition (3) or (4) below is satisfied.

(3) The series switch unit is closer to the power supply module than the bypass wiring portion, and the arc detection unit detects series arc discharge and the noise detection means does not detect predetermined current noise and predetermined high frequency noise in a state where the series switch unit is closed and the parallel switch unit is closed.

(4) The series switch unit is closer to the power conversion device than the bypass wiring portion, and the arc detection unit detects series arc discharge and the noise detection means does not detect predetermined current noise and predetermined high frequency noise in a state where the parallel switch unit is closed.

According to this aspect, the location where the series arc discharge has occurred can be more accurately identified, and the subsequent maintenance work and the like become easy.

In a preferred aspect, the arc detection unit is capable of detecting parallel arc discharge in a portion closer to the power supply module than the power conversion device, and the arc determination unit determines that the parallel arc discharge has occurred closer to the power supply module than the bypass wiring portion in a case where the arc detection unit detects parallel arc discharge and the noise detection means does not detect predetermined current noise and predetermined high frequency noise in a state where the series switch unit is closed and the parallel switch unit is open.

According to this aspect, even in a case where the parallel arc discharge has occurred, it is possible to determine whether or not the parallel arc discharge has occurred closer to the power supply module than the bypass wiring portion. Therefore, the location where the parallel arc has occurred can be identified, and the subsequent maintenance work or the like becomes easy.

In a more preferable aspect, the arc determination unit determines that the parallel arc discharge has occurred closer to the power conversion device than the bypass wiring portion in a case where the arc detection unit detects parallel arc discharge and the noise detection means detects predetermined current noise or predetermined high frequency noise in a state where the series switch unit is closed and the parallel switch unit is open.

According to this aspect, the location where the parallel arc has occurred can be more accurately identified, and the subsequent maintenance work and the like become easy.

One aspect of the present invention is a power supply system including: a power supply module; a power conversion device; an arc detection unit; a positive-electrode-side wiring portion; a negative-electrode-side wiring portion; a bypass wiring portion; a series switch unit; a parallel switch unit; and an arc determination unit, in which the power supply module is connected to the power conversion device via the positive-electrode-side wiring portion and the negative-electrode-side wiring portion, the arc detection unit is capable of detecting parallel arc discharge in a portion closer to the power supply module than the power conversion device and includes a noise detection means, the bypass wiring portion connects the positive-electrode-side wiring portion and the negative-electrode-side wiring portion, the series switch unit is provided in the positive-electrode-side wiring portion or the negative-electrode-side wiring portion, the parallel switch unit is provided in a middle of the bypass wiring portion and is connected in parallel with the power conversion device, the noise detection means is provided in the positive-electrode-side wiring portion or the negative-electrode-side wiring portion and is located closer to the power supply module than a connection portion with the bypass wiring portion, and the arc determination unit determines that the parallel arc discharge has occurred closer to the power supply module than the bypass wiring portion in a case where the arc detection unit detects parallel arc discharge and the noise detection means does not detect predetermined current noise and predetermined high frequency noise in a state where the series switch unit is closed and the parallel switch unit is open.

According to this aspect, since it is possible to determine whether or not the parallel arc discharge has occurred closer to the power supply module than the bypass wiring portion, the location where the parallel arc has occurred can be identified, and the subsequent maintenance work and the like become easy.

In a preferred aspect, the arc determination unit determines that the parallel arc discharge has occurred closer to the power conversion device than the bypass wiring portion in a case where the arc detection unit detects parallel arc discharge and the noise detection means detects predetermined current noise or predetermined high frequency noise in a state where the series switch unit is closed and the parallel switch unit is open.

According to this aspect, the location where the parallel arc has occurred can be identified more, and the subsequent maintenance work and the like become easy.

The above-described aspects can be mutually dependent, some configurations can be cited, or some configurations can be replaced between the aspects as long as the aspects are included in the technical scope of the present invention.

### EFFECT OF INVENTION

According to the power supply system of the present invention, a location where series arc discharge or parallel arc discharge has occurred can be identified.

### BRIEF DESCRIPTION OF DRAWINGS

Fig. 1 is a block diagram of a power supply system according to a first embodiment of the present invention during normal operation.
Fig. 2 is a flowchart of an arc cut-off operation of the power supply system in Fig. 1.
Figs. 3A and 3B are explanatory diagrams of a state of a switch unit in the arc cut-off operation of the power supply system in Fig. 2, Fig. 3A is a block diagram in steps S1-3 and S1-9 in Fig. 2, and Fig. 3B is a block diagram in step S1-6 in Fig. 2.
Figs. 4A and 4B are block diagrams of a power supply system according to another embodiment of the present invention, Fig. 4A is a block diagram when a series switch unit is closed and a parallel switch unit is closed, and Fig. 4B is a block diagram when the series switch unit is opened and the parallel switch unit is closed.
Fig. 5 is a flowchart of an arc cut-off operation of a power supply system according to another embodiment of the present invention.
Fig. 6 is a flowchart of an arc cut-off operation of a power supply system according to still another embodiment of the present invention.

### BEST MODE FOR CARRYING OUT THE INVENTION

Hereinafter, embodiments of the present invention will be described in detail.

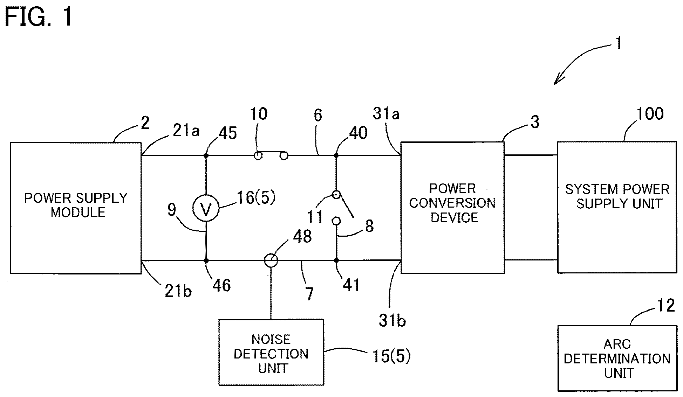

As illustrated in Fig. 1, a power supply system 1 according to a first embodiment of the present invention includes, as main component members, a power supply module 2, a power conversion device 3, an arc detection unit 5, a positive-electrode-side wiring portion 6, a negative-electrode-side wiring portion 7, a bypass wiring portion 8, a measurement wiring portion 9, a series switch unit 10 (series arc cut-off unit), a parallel switch unit 11 (parallel arc short-circuit unit), and an arc determination unit 12, and a system power supply unit 100 can be connected to the power conversion device 3.

The power supply system 1 supplies power generated by the power supply module 2 to the system power supply unit 100 connected to the power conversion device 3.

### (Power supply module 2)

The power supply module 2 is a power generation module that generates power using renewable energy such as a solar cell module or a fuel cell module, or a power storage module such as a secondary battery, and can supply power generated via the power conversion device 3 to the system power supply unit 100.

Both of the power supply modules 2 of the present embodiment use a solar cell module that converts light energy into electric energy.

In the power supply module 2, a plurality of solar cell groups is connected in series or in series and in parallel, and each of the solar cell groups has a plurality of solar cells connected in series.

As illustrated in Fig. 1, the power supply module 2 includes a positive-electrode-side terminal 21a connected to a positive electrode side of each solar cell group and a negative-electrode-side terminal 21b connected to a negative electrode side of each solar cell group.

### (Power conversion device 3)

The power conversion device 3 converts DC power into AC power, and includes a boost converter unit that boosts power generated by the power supply module 2 and an inverter unit that converts the boosted power from DC power into AC power.

### (Arc detection unit 5)

The arc detection unit 5 is a portion that detects arc discharge when the arc discharge occurs in a portion closer to the power supply module 2 than connection terminals 31a and 31b of the power conversion device 3.

That is, in the arc detection unit 5, not only the power supply module 2 but also a wiring member connecting the power supply module 2 and the connection terminals 31a and 31b or the like are detection targets of the arc discharge.

As illustrated in Fig. 1, the arc detection unit 5 mainly includes a noise detection unit 15 (noise detection means) and a voltage measurement unit 16.

The noise detection unit 15 is a portion that detects current noise or high frequency noise at a noise detection position 48 of the negative-electrode-side wiring portion 7.

The voltage measurement unit 16 is provided in the middle of the measurement wiring portion 9 and measures a voltage between the positive-electrode-side wiring portion 6 and the negative-electrode-side wiring portion 7.

### (Positive-electrode-side wiring portion 6)

The positive-electrode-side wiring portion 6 is a wiring portion that connects the positive-electrode-side terminal 21a of the power supply module 2 and the positive-electrode-side connection terminal 31a of the power conversion device 3.

### (Negative-electrode-side wiring portion 7)

The negative-electrode-side wiring portion 7 is a wiring portion that connects the negative-electrode-side terminal 21b of the power supply module 2 and the negative-electrode-side connection terminal 31b of the power conversion device 3.

### (Bypass wiring portion 8)

The bypass wiring portion 8 is a wiring portion that connects the middle of the positive-electrode-side wiring portion 6 and the middle of the negative-electrode-side wiring portion 7, and is a wiring portion that bypasses the power conversion device 3 as viewed from a side of the power supply module 2.

That is, the bypass wiring portion 8 is connected to the middle of the positive-electrode-side wiring portion 6 via a connection part 40, and is connected to the middle of the negative-electrode-side wiring portion 7 via a connection part 41.

### (Measurement wiring portion 9)

The measurement wiring portion 9 is a wiring portion connecting the middle of the positive-electrode-side wiring portion 6 and the middle of the negative-electrode-side wiring portion 7, and is connected to the middle of the positive-electrode-side wiring portion 6 via the connection part 45 and is connected to the middle of the negative-electrode-side wiring portion 7 via the connection part 46.

### (Series switch unit 10)

The series switch unit 10 is a series arc cut-off unit that is provided in the middle of the positive-electrode-side wiring portion 6 and cuts off conduction between the power supply module 2 and the power conversion device 3 in a case where series arc discharge occurs.

The series switch unit 10 can conduct between the power supply module 2 and the power conversion device 3 by being in the closed state, and can cut off the conduction between the power supply module 2 and the power conversion device 3 by being in the open state.

### (Parallel switch unit 11)

The parallel switch unit 11 is a parallel arc short-circuit unit that is provided in the middle of the bypass wiring portion 8 and conducts the positive-electrode-side wiring portion 6 and the negative-electrode-side wiring portion 7 to short-circuit the power supply module 2 and the power conversion device 3 in a case where parallel arc discharge occurs.

By closing the parallel switch unit 11, the positive-electrode-side wiring portion 6 and the negative-electrode-side wiring portion 7 are conducted to be short-circuited, and by opening the parallel switch unit, the conduction between the positive-electrode-side wiring portion 6 and the negative-electrode-side wiring portion 7 can be cut off.

### (Arc determination unit 12)

The arc determination unit 12 determines whether the arc discharge is series arc discharge or parallel arc discharge.

Subsequently, a positional relationship of each member of the power supply system 1 according to the present embodiment will be described.

As illustrated in Fig. 1, in the measurement wiring portion 9, the voltage measurement portion 16 is provided in the middle, the connection part 45 with the positive-electrode-side wiring portion 6 is provided closer to the positive-electrode-side terminal 21a (on an upstream side in the current flow direction) of the power supply module 2 than the connection part 40 (connection portion) with the positive-electrode-side wiring portion 6 of the bypass wiring portion 8, and is further provided closer to the positive-electrode-side terminal 21a (on the upstream side in the current flow direction) of the power supply module 2 than the series switch unit 10. That is, the series switch unit 10 is located between the connection part 45 of the measurement wiring portion 9 and the connection part 40 of the bypass wiring portion 8.

In the measurement wiring portion 9, the connection part 46 with the negative-electrode-side wiring portion 7 is provided closer to the negative-electrode-side terminal 21b of the power supply module 2 than the connection part 41 (connection portion) with the negative-electrode-side wiring portion 7 of the bypass wiring portion 8, and is further provided closer to the negative-electrode-side terminal 21b of the power supply module 2 than the noise detection position 48 of the noise detection unit 15. That is, the noise detection position 48 in the negative-electrode-side wiring portion 7 of the noise detection unit 15 is located between the connection part 46 of the measurement wiring portion 9 and the connection part 41 of the bypass wiring portion 8.

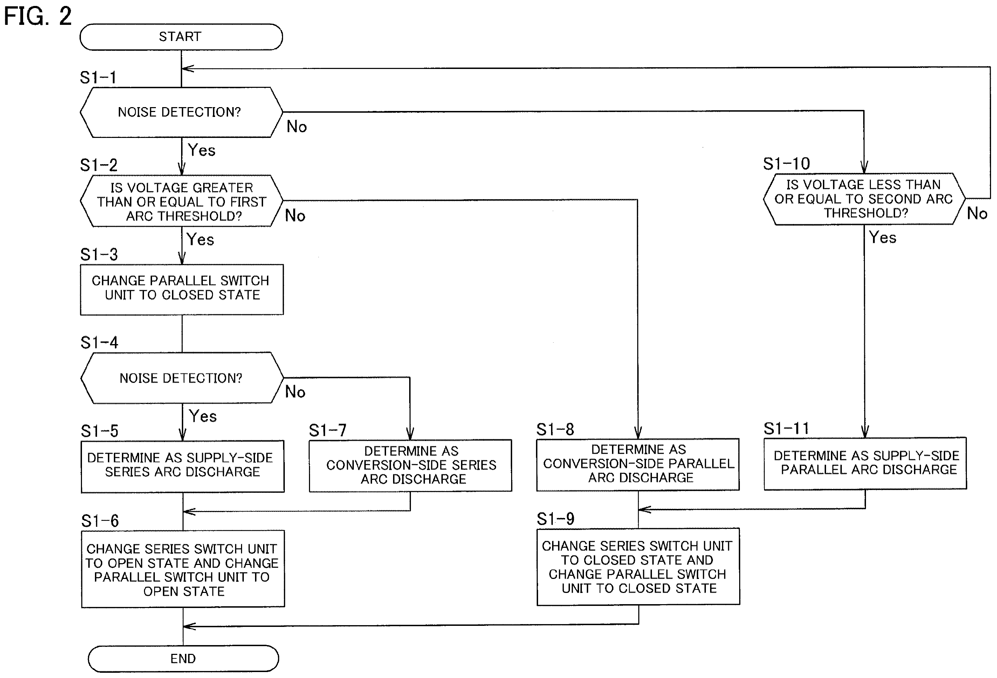

Next, an arc cut-off operation of the power supply system 1 of the present embodiment will be described with reference to a flowchart of Fig. 2.

The arc cut-off operation is performed in parallel with a normal operation of supplying power generated by the power supply module 2 to the system power supply unit 100 via the power conversion device 3.

In other words, in principle, the arc cut-off operation is performed based on the state of the normal operation, that is, the state in which the series switch unit 10 is in the closed state and the parallel switch unit 11 is in the open state as illustrated in Fig. 1.

In the arc cut-off operation, first, the noise detection unit 15 determines whether or not predetermined current noise or predetermined high frequency noise (hereinafter, also simply referred to as noise) is detected at the noise detection position 48 of the negative-electrode-side wiring portion 7 (step S1-1), and when the noise detection unit 15 detects the noise (Yes in step S1-1), it is determined whether or not the voltage between the connection parts 45 and 46 measured by the voltage measurement unit 16 is greater than or equal to a first arc threshold (step S1-2).

The first arc threshold at this time is a threshold serving as a criterion for determining the occurrence of the series arc discharge, and can be appropriately changed according to the minimum operation input voltage or the like in the power conversion device 3, but is preferably, for example, a value of more than 0 V or less than 40 V

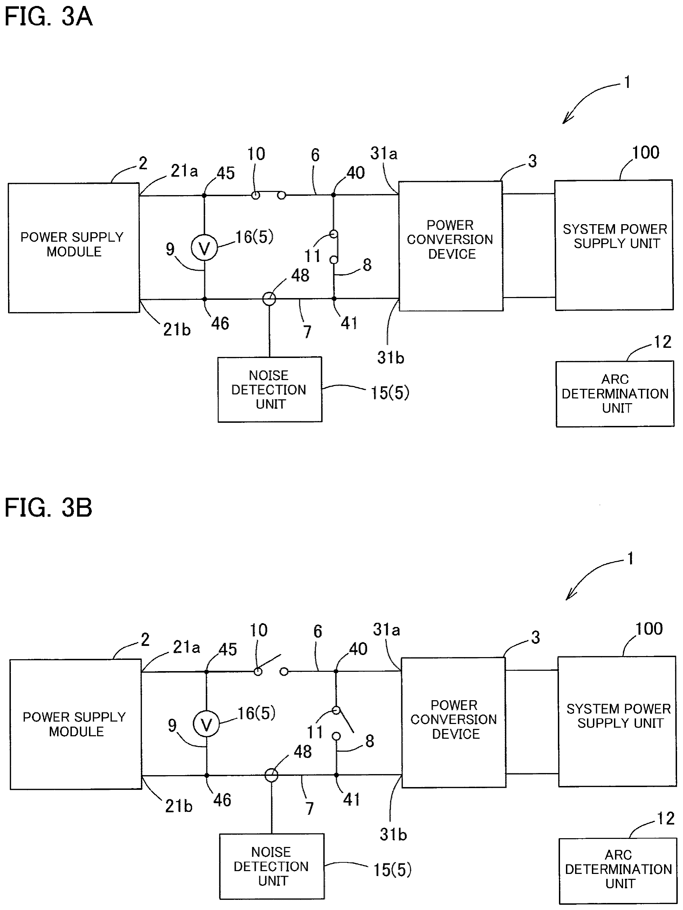

In step S1-2, in a case where the voltage between the connection parts 45 and 46 is greater than or equal to the first arc threshold (Yes in step S1-2), the arc determination unit 12 determines that the series arc discharge occurs, changes the parallel switch unit 11 to the closed state as illustrated in Fig. 3A (step S1-3), and determines whether noise is detected by the noise detection unit 15 (step S1-4).

In step S1-4, in a case where the noise detection unit 15 detects noise, that is, in a case where noise continues (Yes in step S1-4), the arc determination unit 12 determines that the series arc discharge that has occurred is supply-side series arc discharge that has occurred closer to the power supply module 2 than the bypass wiring portion 8 (step S1-5), changes the series switch unit 10 to the open state and changes the parallel switch unit 11 to the open state as in Fig. 3B (step S1-6), and cuts off conduction between the power supply module 2 and the power conversion device 3 to extinguish the supply-side series arc discharge.

On the other hand, in a case where the noise detection unit 15 does not detect the noise in step S1-4, that is, in a case where the noise has disappeared (No in step S1-4), the arc determination unit 12 determines that the series arc discharge that has occurred is the conversion-side series arc discharge that has occurred closer to the power conversion device 3 than the bypass wiring portion 8 (step S1-7), and proceeds to step S1-6 to cut off the conduction between the power supply module 2 and the power conversion device 3 and extinguish the conversion-side series arc discharge.

In a case where the noise detection unit 15 detects noise (Yes in S1-1) and the voltage is less than the first arc threshold (No in step S1-2), the arc determination unit 12 determines that parallel arc discharge has occurred between the positive-electrode-side wiring portion 6 and the negative-electrode-side wiring portion 7, and the parallel arc discharge is conversion-side parallel arc discharge that has occurred closer to the power conversion device 3 than the bypass wiring portion 8 (step S1-8), changes (maintains) the series switch unit 10 to the closed state and changes the parallel switch unit 11 to the closed state as in Fig. 3A (step S1-9), and causes the bypass wiring portion 8 to conduct the positive-electrode-side wiring portion 6 and the negative-electrode-side wiring portion 7 to extinguish the conversion-side parallel arc discharge.

In a case where the noise detection unit 15 does not detect noise in step S1-1 (No in step S1-1) and the voltage between the connection parts 45 and 46 measured by the voltage measurement unit 16 is less than or equal to a second arc threshold (Yes in step S1-10), the arc determination unit 12 determines that parallel arc discharge has occurred between the positive-electrode-side wiring portion 6 and the negative-electrode-side wiring portion 7 and the parallel arc discharge is supply-side parallel arc discharge that has occurred closer to the power supply module 2 than the bypass wiring portion 8 (step S1-11), and proceeds to step S1-9, and causes the bypass wiring portion 8 to conduct the positive-electrode-side wiring portion 6 and the negative-electrode-side wiring portion 7 to extinguish the supply-side parallel arc discharge.

The second arc threshold at this time is a threshold serving as a criterion for determining the occurrence of parallel arc discharge, and can be appropriately changed according to the minimum operation input voltage or the like in the power conversion device 3. The second arc threshold may be the same value as or different from the first arc threshold.

In a case where the noise detection means does not detect noise in step S1-1 (No in step S1-1) and the voltage between the connection parts 45 and 46 measured by the voltage measurement unit 16 exceeds the second arc threshold (No in step S1-10), the arc determination unit 12 determines that no arc discharge has occurred and returns to step S1-1.

According to the power supply system 1 of the present embodiment, the noise detection unit 15 is provided in the negative-electrode-side wiring portion 7 and is located closer to the power supply module 2 than the connection part 41 with the bypass wiring portion 8, the series switch unit 10 is closer to the power supply module 2 than the bypass wiring portion 8, and the arc determination unit 12 determines that the series arc discharge is the supply-side series arc discharge that has occurred closer to the power supply module 2 than the bypass wiring portion 8 on the condition that the noise detection unit 15 and the voltage measurement unit 16 of the arc detection unit 5 detect the series arc discharge and the noise detection unit 15 detects the predetermined current noise or the predetermined high frequency noise in the state where the series switch unit 10 is in the closed state and the parallel switch unit 11 is in the closed state. Therefore, the location where the series arc has occurred can be identified, and the subsequent maintenance work and the like become easy.

According to the power supply system 1 of the present embodiment, on the condition that the noise detection unit 15 and the voltage measurement unit 16 of the arc detection unit 5 detect the series arc discharge and the noise detection unit 15 does not detect the predetermined current noise and the predetermined high frequency noise in the state where the series switch unit 10 is in the closed state and the parallel switch unit 11 is in the closed state, the arc determination unit 12 determines that the series arc discharge is the conversion-side series arc discharge that has occurred closer to the power conversion device 3 than the bypass wiring portion 8. Therefore, the location where the series arc has occurred can be more accurately identified, and the subsequent maintenance work and the like become easy.

According to the power supply system 1 of the present embodiment, in a case where the noise detection unit 15 and the voltage measurement unit 16 of the arc detection unit 5 detect the parallel arc discharge, and the noise detection unit 15 does not detect the predetermined current noise and the predetermined high frequency noise in the state where the series switch unit 10 is in the closed state and the parallel switch unit 11 is in the open state, the arc determination unit 12 determines that the parallel arc discharge is the supply-side parallel arc discharge that has occurred closer to the power supply module 2 than the bypass wiring portion 8. Therefore, since even in a case where the parallel arc discharge has occurred, it is possible to determine whether the parallel arc discharge has occurred closer to the power supply module 2 than the bypass wiring portion 8, the location where the parallel arc has occurred can be identified, and the subsequent maintenance work and the like become easy.

According to the power supply system 1 of the present embodiment, in a case where the arc detection unit 5 detects the parallel arc discharge and the noise detection unit 15 detects the predetermined current noise or the predetermined high frequency noise in the state where the series switch unit 10 is in the closed state and the parallel switch unit 11 is in the open state, the arc determination unit 12 determines that the parallel arc discharge is the conversion-side parallel arc discharge that has occurred closer to the power conversion device 3 than the bypass wiring portion 8. Therefore, the location where the parallel arc has occurred can be more accurately identified, and the subsequent maintenance work and the like become easy.

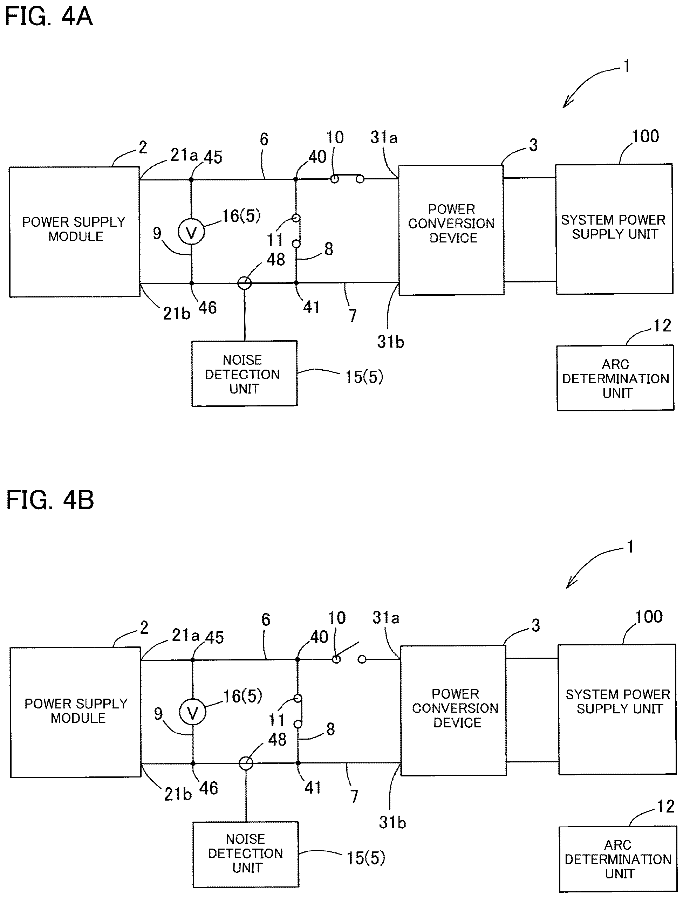

In the above embodiment, the series switch unit 10 is provided closer to the power supply module 2 than the bypass wiring portion 8, but the present invention is not limited thereto. As illustrated in Fig. 4A, the series switch unit 10 may be provided closer to the power conversion device 3 than the bypass wiring portion 8. That is, the series switch unit 10 may be provided on the downstream side of the bypass wiring portion 8 in an electric flow direction of the positive-electrode-side wiring portion 6. In this case, in steps S1-3 and S1-9, as in the above-described embodiment, the series switch unit 10 may be closed as illustrated in Fig. 4A, but the series switch unit 10 may be opened as illustrated in Fig. 4B.

In the embodiment described above, after the noise is detected by the noise detection unit 15 in step S1-1, the voltage between the connection parts 45 and 46 measured by the voltage measurement unit 16 in step S1-2 is measured, but the present invention is not limited thereto.

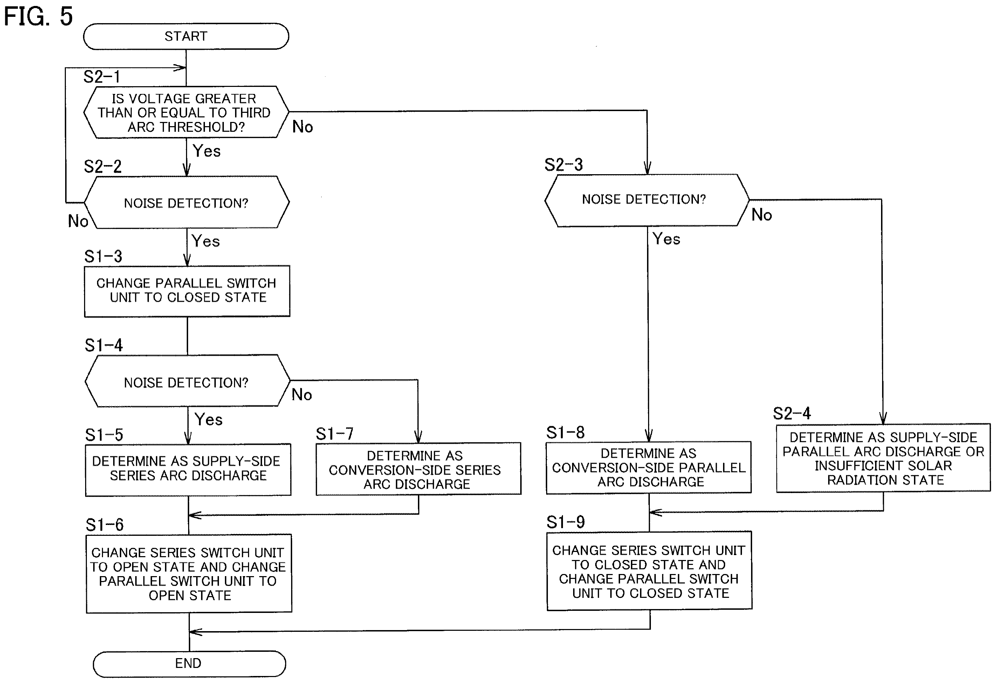

As illustrated in Fig. 5, after the voltage between the connection parts 45 and 46 measured by the voltage measurement unit 16 is measured in step S2-1, the noise may be detected by the noise detection unit 15 in step S2-2 or step S2-3.

At this time, in a case where the voltage is greater than or equal to a third arc threshold in step S2-1 and noise is detected in step S2-2, the process proceeds to step S1-3, and in a case where the voltage is greater than or equal to the third arc threshold in step S2-1 and noise is not detected in step S2-2, the process returns to step S2-1.

Furthermore, in a case where the voltage is less than the third arc threshold in step S2-1 and noise is detected in step S2-3, the process proceeds to step S1-8. On the other hand, in a case where the voltage is less than the third arc threshold in step S2-1 and no noise is detected in step S2-3, the process proceeds to step S2-4, and in step S2-4, the arc determination unit 12 determines that supply-side parallel arc discharge occurs closer to the power supply module 2 than the bypass wiring portion 8 or that the state is normal but an insufficient solar radiation state, and the process proceeds to step S1-9.

The third arc threshold can be appropriately changed according to the minimum operation input voltage or the like in the power conversion device 3.

In the embodiment described above, the case where the power supply system 1 includes one power supply module 2 has been described, but the present invention is not limited thereto. The power supply system 1 may include two or more power supply modules 2.

In the embodiment described above, the series switch unit 10 is provided only in the positive-electrode-side wiring portion 6, but the present invention is not limited thereto. The series switch unit 10 may also be provided on the negative-electrode-side wiring portion 7.

In the embodiment described above, the connection part 46 of the measurement wiring portion 9 and the negative-electrode-side wiring portion 7 is provided closer to the power supply module 2 than the connection part 41 between the bypass wiring portion 8 and the negative-electrode-side wiring portion 7, but the present invention is not limited thereto. The connection part 46 of the measurement wiring portion 9 and the negative-electrode-side wiring portion 7 may be provided closer to the power conversion device 3 than the connection part 41 of the bypass wiring portion 8 and the negative-electrode-side wiring portion 7.

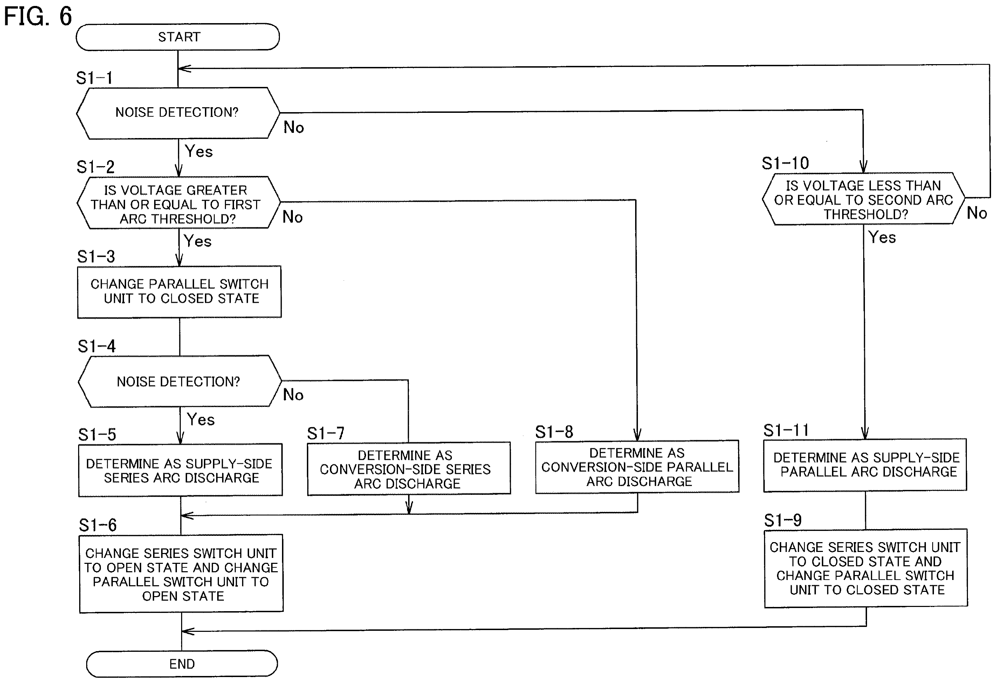

In the embodiment described above, in step S1-8, the arc determination unit 12 determines that the parallel arc discharge has occurred between the positive-electrode-side wiring portion 6 and the negative-electrode-side wiring portion 7 and the parallel arc discharge is the conversion-side parallel arc discharge that has occurred closer to the power conversion device 3 than the bypass wiring portion 8, and then the process proceeds to step S1-9 to extinguish the conversion-side parallel arc discharge. However, the present invention is not limited to this. As illustrated in Fig. 6, after step S1-8, the process may proceed to step S1-6, and the series switch unit 10 may be opened to extinguish the conversion-side parallel arc discharge. In this way, even in a case where the parallel arc discharge and the series arc discharge are erroneously determined in step S1-2, the arc discharge can be extinguished.

In the embodiment described above, each component member can be freely replaced or added between the embodiments as long as it is included in the technical scope of the present invention.

### EXPLANATION OF REFERENCE SIGNS

1: power supply system
2: power supply module
3: power conversion device
5: arc detection unit
6: positive-electrode-side wiring portion
7: negative-electrode-side wiring portion
8: bypass wiring portion
10: series switch unit
11: parallel switch unit
12: arc determination unit
15: noise detection unit (noise detection means)
40, 41: connection part (connection portion)

## Claims

1. A power supply system comprising:
a power supply module;
a power conversion device;
an arc detection unit;
a positive-electrode-side wiring portion;
a negative-electrode-side wiring portion;
a bypass wiring portion;
a series switch unit;
a parallel switch unit; and
an arc determination unit,
wherein the power supply module is connected to the power conversion device via the positive-electrode-side wiring portion and the negative-electrode-side wiring portion,
the arc detection unit is capable of detecting series arc discharge in a portion closer to the power supply module than the power conversion device and includes a noise detection means,
the bypass wiring portion connects the positive-electrode-side wiring portion and the negative-electrode-side wiring portion,
the series switch unit is provided in the positive-electrode-side wiring portion or the negative-electrode-side wiring portion,
the parallel switch unit is provided in a middle of the bypass wiring portion and is connected in parallel with the power conversion device,
the noise detection means is provided in the positive-electrode-side wiring portion or the negative-electrode-side wiring portion and is located closer to the power supply module than a connection portion with the bypass wiring portion, and
the arc determination unit determines that the series arc discharge has occurred closer to the power supply module than the bypass wiring portion when a condition (1) or (2) below is satisfied:
(1) The series switch unit is closer to the power supply module than the bypass wiring portion, and the arc detection unit detects series arc discharge and the noise detection means detects predetermined current noise or predetermined high frequency noise in a state where the series switch unit is closed and the parallel switch unit is closed;
(2) The series switch unit is closer to the power conversion device than the bypass wiring portion, and the arc detection unit detects series arc discharge and the noise detection means detects predetermined current noise or predetermined high frequency noise in a state where the parallel switch unit is closed.

2. The power supply system according to claim 1,
wherein the arc determination unit determines that the series arc discharge has occurred closer to the power conversion device than the bypass wiring portion when a condition (3) or (4) below is satisfied:
(3) The series switch unit is closer to the power supply module than the bypass wiring portion, and the arc detection unit detects series arc discharge and the noise detection means does not detect predetermined current noise and predetermined high frequency noise in a state where the series switch unit is closed and the parallel switch unit is closed;
(4) The series switch unit is closer to the power conversion device than the bypass wiring portion, and the arc detection unit detects series arc discharge and the noise detection means does not detect predetermined current noise and predetermined high frequency noise in a state where the parallel switch unit is closed.

3. The power supply system according to claim 1 or 2,
wherein the arc detection unit is capable of detecting parallel arc discharge in a portion closer to the power supply module than the power conversion device, and
the arc determination unit determines that the parallel arc discharge has occurred closer to the power supply module than the bypass wiring portion in a case where the arc detection unit detects parallel arc discharge and the noise detection means does not detect predetermined current noise and predetermined high frequency noise in a state where the series switch unit is closed and the parallel switch unit is open.

4. The power supply system according to claim 3,
wherein the arc determination unit determines that the parallel arc discharge has occurred closer to the power conversion device than the bypass wiring portion in a case where the arc detection unit detects parallel arc discharge and the noise detection means detects predetermined current noise or predetermined high frequency noise in a state where the series switch unit is closed and the parallel switch unit is open.

5. A power supply system comprising:
a power supply module;
a power conversion device;
an arc detection unit;
a positive-electrode-side wiring portion;
a negative-electrode-side wiring portion;
a bypass wiring portion;
a series switch unit;
a parallel switch unit; and
an arc determination unit,
wherein the power supply module is connected to the power conversion device via the positive-electrode-side wiring portion and the negative-electrode-side wiring portion,
the arc detection unit is capable of detecting parallel arc discharge in a portion closer to the power supply module than the power conversion device and includes a noise detection means,
the bypass wiring portion connects the positive-electrode-side wiring portion and the negative-electrode-side wiring portion,
the series switch unit is provided in the positive-electrode-side wiring portion or the negative-electrode-side wiring portion,
the parallel switch unit is provided in a middle of the bypass wiring portion and is connected in parallel with the power conversion device,
the noise detection means is provided in the positive-electrode-side wiring portion or the negative-electrode-side wiring portion and is located closer to the power supply module than a connection portion with the bypass wiring portion, and
the arc determination unit determines that the parallel arc discharge has occurred closer to the power supply module than the bypass wiring portion in a case where the arc detection unit detects parallel arc discharge and the noise detection means does not detect predetermined current noise and predetermined high frequency noise in a state where the series switch unit is closed and the parallel switch unit is open.

6. The power supply system according to claim 5,
wherein the arc determination unit determines that the parallel arc discharge has occurred closer to the power conversion device than the bypass wiring portion in a case where the arc detection unit detects parallel arc discharge and the noise detection means detects predetermined current noise or predetermined high frequency noise in a state where the series switch unit is closed and the parallel switch unit is open.
